Europäisches Patentamt

European Patent Office

Office européen des brevets

(19)

(11) Publication number: **0 083 210**
**B1**

(12) **EUROPEAN PATENT SPECIFICATION**

(45) Date of publication of patent specification: 26.11.86

(51) Int. Cl.⁴: **H 01 L 27/10,** H 01 L 21/26

(21) Application number: 82306891.1

(22) Date of filing: 23.12.82

(54) A semiconductor device which prevents soft errors.

(30) Priority: 29.12.81 JP 214809/81

(43) Date of publication of application:
06.07.83 Bulletin 83/27

(45) Publication of the grant of the patent:
26.11.86 Bulletin 86/48

(84) Designated Contracting States:
DE FR GB

(56) References cited:
EP-A-0 023 782
EP-A-0 030 856

PATENT ABSTRACTS OF JAPAN, vol. 5, no.
179(E82)(851), 17th November 1981

PATENT ABSTRACTS OF JAPAN, vol. 5, no.
30(E-47)(702), 24th February 1981

(73) Proprietor: FUJITSU LIMITED
1015, Kamikodanaka Nakahara-ku
Kawasaki-shi Kanagawa 211 (JP)

(72) Inventor: Tatematsu, Takeo
2-33, 1550, Shimokurata-cho Totsuka-ku
Yokohama-shi Kanagawa 244 (JP)

(74) Representative: Fane, Christopher Robin King
et al
HASELTINE LAKE & CO. Hazlitt House 28
Southampton Buildings Chancery Lane
London, WC2A 1AT (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor device which prevents soft errors by being provided with improved capacitors. More particularly, it relates to a dynamic semiconductor memory device having improved capacitors for storing charges.

In recent years, the degree of integration of a semiconductor device has been greatly improved. In accordance with this improvement, the capacity of a capacitor integrated in a semiconductor device has become smaller and smaller. Because of the small capacity of the capacitor, the capacitor is easily charged with alpha particles radiating from the package material of the semiconductor device. When, for example, the capacitor is a capacitor for storing data in a dynamic semiconductor memory device, the data stored in the capacitor is easily destroyed by the alpha particles. This destruction of data due to alpha particles is referred to as soft errors. Especially, in a dynamic semiconductor memory device having a capacity of 64k bits or more, the occurrence of soft errors due to alpha particles has become a serious problem, and various attempts have been made to solve this problem.

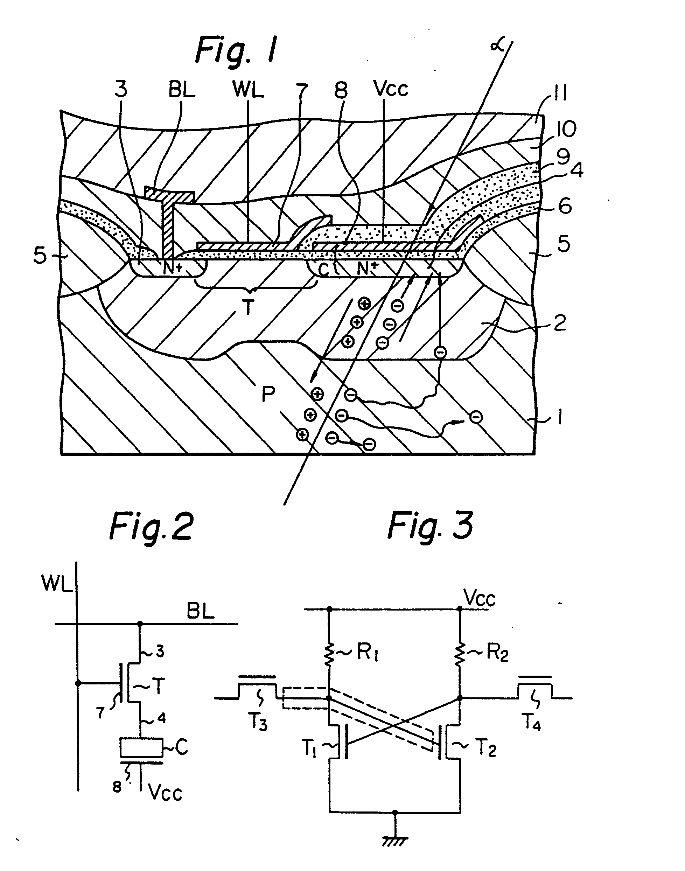

The principle of soft errors due to alpha particles is described with reference to Figs. 1 and 2.

Figure 1 is a cross-sectional view of a conventional dynamic memory cell illustrating the physical structure thereof, and Fig. 2 is an equivalent circuit diagram of the memory cell of Fig. 1. In Figs. 1 and 2, 1 is a P-type semiconductor substrate; 2 is an operatively formed depletion layer; 3 is a first $N^+$-type diffusion region connected to a bit line BL and operatively functioning as the drain of a metal-oxide semiconductor (MOS) transistor T; 4 is a second $N^+$-type diffusion region operatively functioning as the source of the transistor T and as one of the electrodes of a charge-storage capacitor C; 5 is an isolation region for isolating the transistor T from adjacent transistors (not shown); 6 is a thin insulation layer; 7 is a gate electrode connected to a word line WL; 8 is the other electrode of the charge-storage capacitor C and is connected to a power supply line Vcc; 9 is a thick insulation layer; 10 is a first phosphosilicate glass layer formed before formation of the bit line BL; and 11 is a second phosphosilicate glass layer formed after formation of the bit line BL. Hereinafter, 4 is referred to as a charge-storage region.

When electrons are stored in the charge-storage region 4, that is, when the region 4 is at a low potential, the stored data is "0". When no electrons are stored in the charge-storage region 4, that is, when the region 4 is at a high potential, the stored data is "1".

Soft errors due to alpha particles result when no electrons are stored in the charge-storage region 4, i.e., when the stored data is "1". When alpha particles penetrate into the memory device, a number of electron-hole pairs are generated within the depletion layer 2 and the substrate 1 along the penetration path, as is illustrated in Fig. 1. Because the substrate 1 is an equipotential region, the electrons of the electron-hole pairs generated within the substrate 1 move in accordance with a certain diffusion coefficient, with the result that part of the electrons reach the depletion layer 2. Since a positive voltage Vcc is applied to the electrode 8, the depletion layer 2 has an electric field gradient. Therefore, the upper portion of the depletion layer 2 contacting the insulation layer 6 has a higher electric potential than the lower portion of the depletion layer 2 contacting the substrate 1. Electrons, arriving from the substrate at the boundary surface between the substrate 1 and the depletion layer 2, or generated in the depletion layer 2 due to alpha particles, are forced by the electric field gradient to move toward the upper portion of the depletion layer 2 and penetrate into the charge-storage region 4, which has a high electric potential. As a result, the stored data "1" is changed to "0", thereby creating a soft error.

Soft errors may also occur in a conventional static memory cell such as the one shown in Fig. 3. In Fig. 3, $T_1$ and $T_2$ are MOS transistors which are cross-coupled to each other. $R_1$ and $R_2$ are load resistors, and $T_3$ and $T_4$ are transfer gates. In this well-known static memory cell, if an alpha particle penetrates into the drain region of the transistor $T_1$, which region is connected to the gate of the transistor $T_2$, as is illustrated by the dotted line, the state of the transistor $T_2$ may be inverted.

Since the capacity of the charge-storage region has become smaller and smaller due to improvement of the degree of integration of a semiconductor memory device, the problem of soft errors due to alpha particles has become more and more serious.

The alpha particles radiate with a constant probability from radioactive materials such as uranium, thorium, americium, and the like contained in the ceramic material and the like of the memory package. These alpha particles penetrate into the interior of the memory device and thereby cause soft errors. The energy of the alpha particles is up to 9 megaelectronvolts.

Conventionally, in order to prevent the alpha particles from penetrating into the memory device, the memory device is coated with a film of, for example, varnish or the like having a thickness of about 80 micrometers. However, such a thick coating film results in various problems. For example, the coating film produces a gas and the package becomes filled with the gas, disadvatangeously resulting in a decrease in the sealing effect of the package; and when the solvent of the varnish hardens, wires connected to the memory device are unnecessarily subjected to stress or are cut. The number of soft errors due to alpha particles can be decreased if the depth of the depletion layer 2 is made as small as possible because most of the electrons which penetrate into the charge-storage region 4 are electrons generated in the depletion layer 2. Therefore, conventionally, in order to decrease the depth of the depletion layer, P-type ions are injected into the surface of the substrate to increase the concentration of P-type impurities at the surface of the substrate. However, if the amount of P-type ions injected is too great, an N-type channel region cannot be formed. Therefore, the amount of P-type ions injected into the surface of the P-type substrate must, naturally, be limited to a small amount, and, accordingly, the depth of the depletion layer cannot be very small.

It is, therefore, an object of the present invention to provide a semiconductor device in which the number of soft errors due to alpha particles is greatly reduced.

According to the present invention the above object is attained by means of a semiconductor device, comprising:

a semiconductor substrate having a first type of conductivity;

an impurity diffused layer having a second type of conductivity opposite to said first type of conductivity and being formed at the surface of said semiconductor substrate;

an insulation layer formed within said impurity diffused layer to divide said impurity diffused layer into a first impurity diffused layer and a second impurity diffused layer, forming upper and lower layers electrically isolated from one another; and

fixed voltage supply means ($V_{cc}$), electrically connected to said second impurity diffused layer, for supplying a fixed voltage to said second impurity diffused layer.

According to another aspect of the present invention, the above-mentioned semiconductor device comprises a dynamic memory cell comprising a capacitor, consisting of an upper impurity diffused layer, a second insulation layer covering the upper impurity diffused layer, and an electrode covering the second insulation layer, and an MOS transistor adjacent to the capacitor.

For convenience, the various impurity diffused layers will be referred to hereinafter as 'diffused layers'.

The above object and advantage, as well as other features, of the present invention will be better understood from the following description of the preferred embodiments with reference to the accompanying drawings, in which:

Fig. 1 is a cross-sectional view of a conventional dynamic memory cell illustrating the physical structure thereof;

Fig. 2 is an equivalent circuit diagram of the memory cell of Fig. 1;

Fig. 3 is a circuit diagram of a conventional static memory cell;

Fig. 4A is a plan view of MOS capacitors according to an embodiment of the present invention;

Fig. 4B is a cross-sectional view of the MOS capacitors of Fig. 4A taken along the line Y—Y of Fig. 4A;

Fig. 4C is a cross-sectional view of the MOS capacitors of Fig. 4A taken along the line X—X of Fig. 4A;

Fig. 5 is a cross-sectional view of a dynamic memory cell according to another embodiment of the present invention; and

Fig. 6 is an equivalent circuit diagram of the dynamic memory cell of Fig. 5.

The embodiments of the present invention will now be described with reference to the drawings.

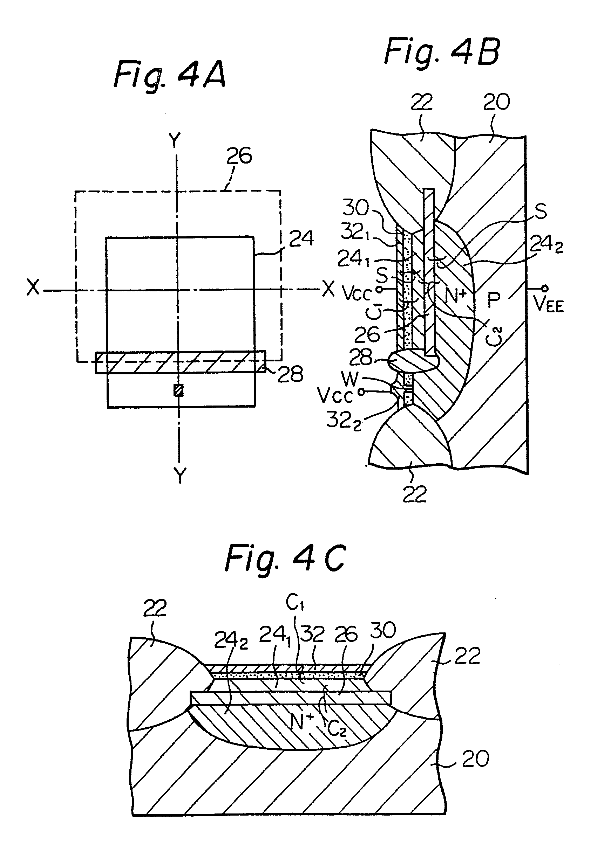

Referring to Figs. 4A through 4C, on a P-type semiconductor substrate 20 and a region surrounded by an isolation region 22, an $N^+$-type diffusion layer 24 is formed so as to have a depth of one or two micrometers by using, for example, phosphorus ions. As is illustrated in Fig. 4C, the diffusion layer 24 is divided into two layers by an insulation layer 26, i.e., into an upper diffusion layer $24_1$, and a lower diffusion layer $24_2$.

The insulation layer 26 is a film of $SiO_2$ formed by ion implanting oxygen with a predetermined energy into the diffusion layer 24. The implanted oxygen is chemically combined with silicon in the middle portion of the diffusion layer 24 to form the $SiO_2$ film. The insulation layer 26 does not extend completely through the diffusion layer 24; rather, as can be seen from Figs. 4A and 4B, it extends from an end portion of the isolation region 22 to another isolation region 28 which is provided in the diffusion layer 24. That is, the insulation layer 26 covers a part of the surface of the lower diffusion layer $24_2$. In Fig. 4C, the upper diffusion layer $24_1$ is covered by an insulation layer 30, and the insulation layer 30 is covered by a metal layer 32. In Fig. 4B, the isolation region 28 divides the metal layer 32 into two metal layers $32_1$ and $32_2$. The metal layer $32_1$ is operatively connected to a power supply $V_{cc}$, and the lower diffusion layer $24_2$ is operatively connected through a window W to the power supply $V_{cc}$. The substrate 20 is operatively connected to a negative-voltage power supply $V_{EE}$. For the purpose of simplicity, the depletion layer is not illustrated in Figs. 4B and 4C. Due to this structure, the upper diffusion layer $24_1$, forms a charge-storage region. More precisely, the metal layer $32_1$, the insulation layer 30, and the upper diffusion layer $24_1$ form a first MOS capacitor $C_1$; and the upper diffusion layer $24_1$ the insulation layer 26, and the lower diffusion layer $24_2$ form a second MOS capacitor $C_2$. The first capacitor $C_1$ and the second capacitor $C_2$ are connected in parallel because they have in common the upper diffusion layer $24_1$, and the same voltage is applied to the metal layers $32_1$ and $32_2$. When a power supply voltage, also referred to as $V_{cc}$, is applied to the metal layers $32_1$ and $32_2$, charges are stored in the first and the second capacitors connected in parallel. If the power supply voltage $V_{cc}$ is positive, electrons are stored in the upper diffusion layer $24_1$.

When an alpha particle penetrates into the MOS capacitors illustrated in Figs. 4A through 4C, electron-hole pairs are generated in the diffusion layers $24_1$ and $24_2$ and in the semiconductor substrate 20. The electrons generated in the lower

diffusion layer $24_2$ and in the depletion layer (not shown in Figs. 4B and 4C), however, are absorbed through the window W by the power supply $V_{cc}$ because the positive power supply voltage $V_{cc}$ is applied to the lower diffusion layer $24_2$. Therefore, the electrons generated in the lower diffusion layer $24_2$ and in the substrate 20 can not cause soft errors. Further, the amount of electrons generated in the upper diffusion layer $24_1$ can be limited by making the upper diffusion layer $24_1$ as thin as possible. Still further, as was mentioned before, since the structure illustrated in Figs. 4A through 4C realizes two capacitors connected in parallel, the total capacity of the capacitors in this first embodiment is twice that of the conventional capacitor shown in Fig. 1, assuming that the surface area of the structure of the conventional capacitor is the same as that of the structure of the two capacitors of this embodiment. Therefore, according to this embodiment, the degree of integration of the device is increased.

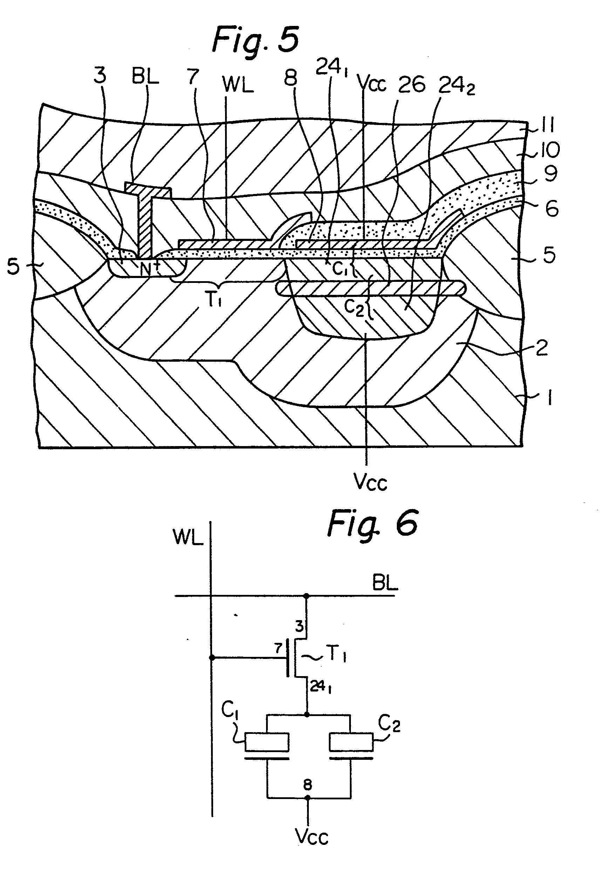

Another embodiment of the present invention will now be described with reference to Figs. 5 and 6, in which a dynamic memory cell is illustrated.

In Fig. 5, the same portions as in the conventional cell of Fig. 1 are designated by the same reference numerals. However, the capacitors $C_1$ and $C_2$ illustrated in Figs. 4A through 4C are provided in place of the change-storage region 4 illustrated in Fig. 1. In Fig. 5, a cross section of the capacitors, corresponding to the cross-sectional view of Fig. 4C, is illustrated. Thus, the capacitors $C_1$ and $C_2$ for storing data in the device of Fig. 5 comprise the upper diffusion layer $24_1$, the lower diffusion layer $24_2$, and the insulation layer 26 between the layers $24_1$ and $24_2$. The insulation layer 26 may be a rectangular plate provided for each memory cell or may be an extended plate, extending in one direction, in which a number of memory cells are provided.

The dynamic memory cell of Fig. 5 also comprises a MOS transistor $T_1$ comprising the diffusion region 3, the upper diffusion layer $24_1$, and the gate electrode 7.

Figure 6 is an equivalent circuit diagram of the dynamic memory cell of Fig. 5. As is shown in Fig. 6, the memory cell comprises the transistor $T_1$ and the two capacitors $C_1$ and $C_2$, the capacitors $C_1$ and $C_2$ being connected in parallel. Except for the above, the constitution of the equivalent circuit diagram is the same as that of the conventional circuit diagram of Fig. 2.

It will be easily seen that, as is the case with the device of the first embodiment, in the second embodiment illustrated in Figs. 5 and 6, the electrons generated in the lower diffusion layer $24_2$ due to alpha particles do not cause any soft errors. Also, in the upper diffusion layer $24_1$, the probability of the generation of electron-hole pairs is very small. Further, the capacity of the charge-storage region is twice the capacity of that in the conventional memory cell. Still further, as an additional advantage in the second embodiment, since the contact area between the upper diffusion layer $24_1$ and the depletion layer 2 is very small in comparison with the conventional device, leakage currents flowing from the upper diffusion layer $24_1$ through the depletion layer 2 to the substrate 1 are small, with the result that the refresh time required for the dynamic memory cell is short.

From the foregoing description, it will be apparent that in a semiconductor device having a semiconductor substrate and a diffusion layer formed at the surface of the substrate and having a type of conductivity opposite to that of the substrate, according to the present invention, by dividing the diffusion layer into upper and lower layers with an insulation layer, the number of soft errors due to alpha particles is decreased, the degree of integration is increased because the capacity of the capacitor per unit area is increased, and, in the case of a dynamic memory cell the refresh time is shortened as compared with the conventional memory cell since the PN junction area is decreased.

The present invention may also be applied to a static memory device.

**Claims**

1. A semiconductor device, comprising:
   a semiconductor substrate (20) having a first type of conductivity;
   an impurity diffused layer having a second type of conductivity opposite to said first type of conductivity and being formed at the surface of said semiconductor substrate;
   an insulation layer (26) formed within said impurity diffused layer to divide said impurity diffused layer into a first impurity diffused layer ($24_1$) and a second impurity diffused layer ($24_2$) forming upper and lower layers electrically isolated from one another; and
   fixed voltage supply means ($V_{cc}$), electrically connected to said second impurity diffused layer, for supplying a fixed voltage to said second impurity diffused layer.

2. A semiconductor device according to claim 1 which includes an isolation region (28), laterally adjacent to said first impurity diffused layer ($24_1$) for electrically isolating said first layer ($24_1$).

3. A semiconductor device as set forth in claim 1, wherein said first impurity diffused layer ($24_1$) is formed on said insulation layer (26) and in said semiconductor substrate, forming a coplanar surface with said semiconductor substrate (20); and further comprising:
   a second insulation layer (30) formed to cover one part of the coplanar surface;
   a first electrode plate ($32_1$) disposed on said second insulation layer (30);
   a second electrode plate ($32_2$) electrically connected to said second impurity diffused layer ($24_2$); and
   an isolation region (28), laterally adjacent to said first impurity diffused layer ($24_1$), for electrically isolating said first layer ($24_1$);
   said fixed voltage supply means ($V_{cc}$) being electrically connected to said first electrode plate $(32_1)$ and said second electrode plate $(32_2)$.

4. A semiconductor device as set forth in claim 3, wherein said first electrode plate $(32_1)$, said second insulation layer (30), and said first impurity diffused layer $(24_1)$ form a first capacitor, and said first impurity diffused layer $(24_1)$, said insulation layer (26), and said second impurity diffused layer $(24_2)$ form a second capacitor connected in parallel to said first capacitor.

5. A semiconductor device as set forth in claim 4, wherein said insulation layer (26) is formed between said first impurity diffused layer $(24_1)$ and said second impurity diffused layer $(24_2)$ and abuts said isolation region (28).

6. A semiconductor device as set forth in claim 5, wherein said first type of conductivity is a P-type conductivity and a positive voltage is operatively applied to said second impurity diffused layer $(24_2)$.

7. A semiconductor device as set forth in claim 3, further comprising an MOS transistor $(T_1)$ comprising:

a third impurity diffused layer (3) having said second type of conductivity, forming one of a drain or a source on the coplanar surface of said semiconductor substrate and being separated from said first and second impurity diffused layers;

a gate electrode $(32_1)$ formed on said second insulation layer (30); and

said first impurity diffused layer functioning as one of a source and a drain.

8. A semiconductor device as set forth in claim 7, wherein said first electrode plate $(32_1)$, said second insulation layer (30) and said first impurity diffused layer $(24_1)$ form a first capacitor, and said first impurity diffused layer $(24_1)$, said insulation layer (26), and said second impurity diffused layer $(24_2)$ form a second capacitor connected in parallel to said first capacitor.

9. A semiconductor device as set forth in claim 8, wherein said insulation layer (26) is formed between said first impurity diffused layer $(24_1$ and said second impurity diffused layer $(24_2)$ and abuts said isolation region (28).

10. A semiconductor device as set forth in claim 9, wherein said MOS transistor and said first and second capacitors form a dynamic cell.

11. A semiconductor device as set forth in claim 10, wherein said first type of conductivity is a P-type conductivity and a positive voltage is applied to said second impurity diffused layer $(24_2)$.

12. A semiconductor device as set forth in claim 11, wherein said gate electrode is connected to a word line and said third impurity diffused layer is connected to a bit line in the semiconductor device.

**Patentansprüche**

1. Halbleitervorrichtung mit:

einem Halbleitersubstrat (20), das von einem ersten Leitfähigkeitstyp ist;

einer Schicht mit diffundierten Verunreinigungen von einem zweiten Leitfähigkeitstyp, der entgegengesetzt zu dem ersten Leitfähigkeitstyp ist, und auf der Oberfläche des genannten Halbleitersubstrats gebildet ist;

einer isolierenden Schicht (26), die innerhalb der mit Verunreinigungen diffundierten Schicht gebildet ist, um die mit Verunreinigungen diffundierte Schicht in eine erste mit Verunreinigungen diffundierte Schicht $(24_1)$ und eine zweite mit Verunreinigungen diffundierte Schicht $(24_2)$ zu teilen, die obere und untere, elektrisch voneinander isolierte Schichten bilden; und

einer Versorgungseinrichtung $(V_{cc})$ fester Spannung, die elektrisch mit der genannten zweiten mit Verunreinigungen diffundierten Schicht verbunden ist, um der genannten zweiten mit Verunreinigungen diffundierten Schicht eine feste Spannung zu liefern.

2. Halbleitervorrichtung nach Anspruch 1, welche einen isolierenden Bereich (28) umfaßt, der seitlich an die genannte erste mit Verunreinigungen diffundierte Schicht $(24_1)$ angrenzt, um die genannte erste Schicht $(24_1)$ elektrisch zu isolieren.

3. Halbleitervorrichtung nach Anspruch 1, bei welcher die genannte mit Verunreinigungen diffundierte Schicht $(24_1)$ auf dem genannten isolierenden Bereich (26) und in dem genannten Halbleitersubstrat gebildet ist, und eine Oberfläche schafft, die koplanar mit dem genannten Halbleitersubstrat (20) ist, und ferner mit:

einer zweiten isolierenden Schicht (30), die gebildet ist, um einen Teil der koplanaren Oberfläche zu bedecken;

einer ersten Elektrodenplatte $(32_1)$, die auf der genannten zweiten isolierenden Schicht (30) angeordnet ist;

einer zweiten Elektrodenplatte $(32_2)$, die elektrisch mit der genannten zweiten mit Verunreinigungen diffundierten Schicht $(24_2)$ verbunden ist; und

einem Isolationsbereich (28), der seitlich an die genannte ersten mit Verunreinigungen diffundierte Schicht $(24_1)$ angrenzt, um die genannte erste Schicht $(24_1)$ elektrisch zu isolieren;

wobei die Versorgungseinrichtung $(V_{cc})$ der festen Spannung elektrisch mit der genannten ersten Elektrodenplatte $(32_1)$ und der genannten zweiten Elektrodenplatte $(32_2)$ verbunden ist.

4. Halbleitervorrichtung nach Anspruch 3, bei welcher die genannte erste Elektrodenplatte $(32_1)$, die genannte zweiten isolierende Schicht (30), und die genannte erste mit Verunreinigungen diffundierte Schicht $(24_1)$ einen ersten Kondensator bilden, und die genannte erste mit Verunreinigungen diffundierte Schicht $(24_1)$, die genannte isolierende Schicht (26) und die genannte zweite mit Verunreinigungen diffundierte Schicht $(24_2)$ einen zweiten Kondensator bilden, der parallel zu dem ersten Kondensator angeschlossen ist.

5. Halbleitervorrichtung nach Anspruch 4, bei welcher die genannte isolierende Schicht (26) zwischen der genannten ersten mit Verunreinigungen diffundierten Schicht (24₁) und der genannten zweiten mit Verunreinigungen diffundierten Schicht (24₂) angeordnet ist und an den genannten isolierenden Bereich (28) angrenzt.

6. Halbleitervorrichtung nach Anspruch 5, bei welcher der genannte erste Leitfähigkeitstyp ein P-Leitfähigkeitstyp ist und eine positive Spannung wirkungsmäßig der genannten zweiten mit Verunreinigungen diffundierten Schicht (24₂) zugeführt wird.

7. Halbleitervorrichtung nach Anspruch 3, ferner mit einem MOS-Transistor (T₁), mit:

einer dritten mit Verunreinigungen diffundierten Schicht (3), die vom zweiten Leitfähigkeitstyp ist und entweder ein Drain oder ein Source auf der koplanaren Oberfläche des genannten Halbleitersubstrats bildet und von den genannten ersten und zweiten mit Verunreinigungen diffundierten Schichten getrennt ist;

einer Gateelektrode (32₁), die auf der genannten zweiten isolierenden Schicht (30) gebildet ist; und

bei welcher die erste mit Verunreinigungen diffundierte Schicht entweder als Source oder als Drain funktioniert.

8. Halbleitervorrichtung nach Anspruch 7, bei welcher die genannte erste Elektrodenplatte (32₁), die genannte zweite isolierende Schicht (30) und die genannte erste mit Verunreinigungen diffundierte Schicht (24₁) einen ersten Kondensator bilden, und die genannte erste mit Verunreinigungen diffundierte Schicht (24₁) die genannte isolierende Schicht (26) und die genannte zweite mit Verunreinigungen diffundierte Schicht (24₂) einen zweiten Kondensator bilden, der parallel zu dem genannten ersten Kondensator angeschlossen ist.

9. Halbleitervorrichtung nach Anspruch 8, bei welcher die genannte isolierende Schicht (26) zwischen der genannten ersten mit Verunreinigungen diffundierten Schicht (24₁) und der genannten zweiten mit Verunreinigungen diffundierten Schicht (24₂) gebildet ist und an den genannten isolierenden Bereich angrenzt.

10. Halbleitervorrichtung nach Anspruch 9, bei welcher der genannten MOS-Transistor und die genannten ersten und zweiten Kondensatoren eine dynamische Zelle bilden.

11. Halbleitervorrichtung nach Anspruch 10, bei welcher der genannte erste Leitfähigkeitstype ein P-Leitfähigkeitstyp ist und eine positive Spannung der genannten zweiten mit Verunreinigungen diffundierten Schicht (24₂) zugeführt wird.

12. Halbleitervorrichtung nach Anspruch 11, bei welcher die genannte Gateelektrode mit einer Wortleitung verbunden ist und die genannte dritte mit Verunreinigungen diffundierte Schicht mit einer Bitleitung in der Halbleitervorrichtung verbunden ist.

**Revendications**

1. Dispositif à semiconducteur, comprenant:
un substrat semiconducteur (20) ayant un premier type de conductivité;

une couche à impuretés diffusées ayant un second type de conductivité opposé au premier type de conductivité et étant formée à la surface du substrat semiconducteur;

une couche isolante (26) formée à l'intérieur de la couche à impuretés diffusées pour diviser la couche à impuretés diffusées en une première couche à impuretés diffusées (24₁) et en une deuxième couche à impuretés diffusées (24₂) constituant des couches supérieure et inférieure isolées électriquement l'une de l'autre; et

un moyen d'alimentation en tension fixe (V$_{CC}$), connecté électriquement à la deuxième couche à impuretés diffusées, pour fournir une tension fixe à la deuxième couche à impuretés diffusées.

2. Dispositif à semiconducteur selon la revendication 1, qui comprend une région isolante (28), latéralement voisine de la première couche à impuretés diffusées (24₁) pour isoler électriquement la première couche (24₁).

3. Dispositif à semiconducteur selon la revendication 1, dans lequel la première couche à impuretés diffusées (24₁) est formée sur la couche isolante (26) et dans le substrat semiconducteur, constituant une surface dans le même plan avec le substrat semiconducteur (20); et comprenant en outre:

une deuxième couche isolante (30) formée pour recouvrir une partie de la surface dans le même plan;

une première plaque d'électrode (32₁) disposée sur la deuxième couche isolante (30);

une seconde plaque d'électrode (32₂) connectée électriquement à la deuxième couche à impuretés diffusées (24₂); et

une région isolante (28), latéralement voisine de la première couche à impuretés diffusées (24₁), pour isoler électriquement la première couche (24₁);

le moyen d'alimentation en tension fixe (V$_{CC}$) étant connecté électriquement à la première plaque d'électrode (32₁) et à la seconde plaque d'électrode (32₂).

4. Dispositif à semiconducteur selon la revendication 3, dans lequel la première plaque d'électrode (32₁) la deuxième couche isolante (30), et la première couche à impuretés diffusées (24₁) constituent un premier condensateur, et la première couche à impuretés diffusées (24₁), la couche isolante (26), et la deuxième couche à impuretés diffusées (24₂) constituent un second condensateur connecté en parallèle au premier condensateur.

5. Dispositif à semiconducteur selon la revendication 4, dans lequel la couche isolante (26) est formée entre la première couche à impuretés diffusées (24₁) et la deuxième couche à impuretés diffusées (24₂) et touche la région isolante (28).

6. Dispositif à semiconducteur selon la revendication 5, dans lequel le premier type de conductivité est une conductivité de type P et une tension positive est appliquée activement à la deuxième couche à impuretés diffusées $(24_2)$.

7. Dispositif à semiconducteur selon la revendication 3, comprenant en outre un transistor MOS $(T_1)$ comprenant:

une troisième couche à impuretés diffusées (3) ayant le second type de conductivité, constituant soit un drain, soit une source à la surface dans le même plan du substrat semiconducteur et étant séparée des première et deuxième couches à impuretés diffusées;

une électrode de grille $(32_1)$ formée sur la deuxième couche isolante (30); et

la première couche à impuretés diffusées fonctionnant comme une source ou comme un drain.

8. Dispositif à semiconducteur selon la revendication 7, dans lequel la première plaque d'électrode $(32_1)$, la deuxième couche isolante (30) et la première couche à impuretés diffusées $(24_1)$ constituent un premier condensateur, et la première couche à impuretés diffusées $(24_1)$, la couche isolante (26), et la deuxième couche à impuretés diffusées $(24_2)$ constituent un second condensateur connecté en parallèle au premier condensateur.

9. Dispositif à semiconducteur selon la revendication 8, dans lequel ladite couche isolante (26) est formée entre ladite première couche à impuretés diffusées $(24_1)$ et ladite seconde couche à impuretés diffusées $(24_2)$ et touche ladite région isolante (28).

10. Dispositif à semiconducteur selon la revendication 9, dans lequel ledit transistor MOS et lesdits premier et second condensateurs forment une cellule dynamique.

11. Dispositif à semiconducteur selon la revendication 10, dans lequel ledit premier type de conductivité est une conductivité de type P et une tension positive est appliquée à ladite seconde couche à impuretés diffusées $(24_2)$.

12. Dispositif à semiconducteur selon la revendication 11, dans lequel ladite électrode de grille est connectée à un fil de mot et ladite seconde couche à impuretés diffusées est connectée à un fil de bit dans le dispositif semiconducteur.

*Fig. 1*

*Fig. 2*

*Fig. 3*

# Fig. 4A

# Fig. 4B

# Fig. 4C

## Fig. 5

## Fig. 6